# Europäisches Patentamt
# European Patent Office
# Office européen des brevets

(19)

(11) Numéro de publication: **0 170 558**
**B1**

(12) **FASCICULE DE BREVET EUROPEEN**

(45) Date de publication du fascicule du brevet: **25.04.90**

(51) Int. Cl.⁵: **G 01 R 33/34**

(21) Numéro de dépôt: **85401265.5**

(22) Date de dépôt: **25.06.85**

(54) **Dispositif de création et/ou de réception d'un champ magnétique alternatif pour appareil exploitant la résonance magnétique nucléaire.**

(30) Priorité: **10.07.84 FR 8410939**

(43) Date de publication de la demande:
**05.02.86 Bulletin 86/06**

(45) Mention de la délivrance du brevet:
**25.04.90 Bulletin 90/17**

(84) Etats contractants désignés:
**DE GB IT NL**

(56) Documents cités:
**EP-A-0 071 896**
**EP-A-0 073 375**
**EP-A-0 084 946**
**EP-A-0 107 238**

(73) Titulaire: **GENERAL ELECTRIC CGR S.A.**
**100, rue Camille-Desmoulins**
**F-92130 Issy les Moulineaux (FR)**

(72) Inventeur: **Chesneau, André**
**THOMSON-CSF SCPI 173, bld Haussmann**
**F-75379 Paris Cedex 08 (FR)**
Inventeur: **Prevot, Claude**
**THOMSON-CSF SCPI 173, bld Haussmann**
**F-75379 Paris Cedex 08 (FR)**

(74) Mandataire: **Ballot, Paul Denis Jacques et al**
**Cabinet Ballot-Schmit 7, rue le Sueur**
**F-75116 Paris (FR)**

## Description

L'invention a pour objet un dispositif de création et/ou de réception d'un champ magnétique alternatif pour appareils exploitant la résonance magnétique nucléaire. Il trouve son application particulièrement dans le domaine médical.

Un appareil de mesure de la résonance magnétique nucléaire comporte essentiellement des moyens de création d'un champ orientateur inductif $B_0$ dirigé selon un axe Z'Z, des moyens de création d'un premier gradient de champ selon ce même axe et des moyens de création d'un deuxième gradient de champ selon un plan perpendiculaire à cet axe. Avec ces champs constants on peut discriminer une ligne dans une tranche d'un volume d'examen. Les moments magnétiques des noyaux d'un corps soumis à ces champs étant orientés par le champ orientateur, leur mise en précession est obtenue au moyen d'un champ magnétique alternatif d'excitation. La fréquence de ce champ d'excitation est déterminée en fonction de l'intensité du champ orientateur. Elle correspond à la vitesse de précession libre des moments des noyaux sous l'effet de ce champ orientateur. Typiquement pour une induction variant entre 0,15 teslas et 2 teslas cette fréquence évolue entre 6 MHz et 80 MHz. Pour une structure donnée des moyens de création du champ orientateur et donc pour une intensité donnée de celui-ci, la fréquence d'excitation est imposée. Le champ d'excitation est orthogonal au champ orientateur. Les lignes de champ du champ d'excitation sont donc contenues dans des plans parallèles à la direction du deuxième gradient de champ.

La caractéristique essentielle du champ d'excitation est son homogénéité. En effet, il convient d'exciter pareillement tous les noyaux du corps qui se trouvent dans le volume, la tranche, ou la ligne, soumis à investigation. Un dispositif décrit dans EP—A—0073375 présente une structure apte à créer un tel champ. Elle comporte quatre fils conducteurs, sensiblement parallèles, et situés sur les arêtes d'un parallèlépipède rectangle. Deux conducteurs situés de part et d'autre d'une face de ce parallèlépipède sont parcourus par un courant égal mais de sens inverse au courant qui parcourt les deux conducteurs situés de part et d'autre de la face opposée à cette face. Le champ magnétique d'excitation produit est sensiblement perpendiculaire aux deux autres faces de ce parallèlépipède. On peut déterminer que l'inhomogénéité, tant en intensité qu'en direction, de ce champ d'excitation créé est de l'ordre de 10% dans un volume réduit de 50% par rapport au volume du parallélépipède. Dans un appareil exploitant le phénomène de résonance magnétique nucléaire la structure d'émission sert d'antenne de réception pour la mesure de l'énergie cédée par les noyaux pendant leur retour à l'état orienté. En conséquence l'inhomogénéité à l'émission se retrouve également à la réception. Il en résulte une inhomogénéité du signal reçu de l'ordre de 20%. L'un des buts de la présente invention consiste à améliorer l'homogénéité du champ alternatif d'excitation.

La demande de brevit EP—A—0 087 976 décrit une antenne qui résout en partie ce problème d'homogeneïté quand la forme de cette antenne est cylindrique circulaire.

Par ailleurs, le champ d'excitation tel que définie précédemment, dans la zone utile (celle qui est circonscrite par la parallélépipède), reste toujours orienté dans une seule direction. Selon une représentation universellement admise un champ alternatif de direction constante peut être décomposé en deux composantes, d'intensité constante, d'orientation symétrique par rapport à ce champ alternatif, et tournant sur elles-mêmes en des sens opposés. Or, pour l'excitation des noyaux, seule une de ces composantes tournantes est utile. C'est la composante qui tourne dans un sens convenable par rapport au sens d'orientation du champ $B_0$. En conséquence, à l'émission, pour une intensité donnée du champ d'excitation, il en résulte une excitation deux fois moins grande des noyaux. De même à la réception pour une précession donnée des noyaux la mesure de l'énergie cédée est proportionnelle à la moitié de cette précession. En conséquence, autant à l'émission la puissance mise en jeu est supérieure à la puissance utile, autant à la réception la puissance reçue est inférieure à la puissance émise par les noyaux. La perte d'efficacité à l'émission peut être négligée encore que la puissance de cette émission doive être réduite pour des raisons d'ordre physiologiques quand le corps examiné est un corps humain. Par contre le défaut de sensibilité en réception se traduit par un affaiblissement du signal reçu ce qui est très gênant du fait de la faiblesse même des signaux émis par les noyaux. En pratique, l'énergie mesurée est de l'ordre de 150 dB sous le watt.

La présente invention a pour objet de remédier aux inconvénients cités en proposant une structure d'excitation propre à crée un champ d'excitation plus homogène et par ailleurs propre à créer et à recevoir un champ d'excitation tournant.

L'invention concerne un dispositif de création et/ou de réception d'un champ magnétique alternatif pour appareil exploitant la résonance magnétique nucléaire, dans lequel des fils conducteurs sensiblement parallèles sont disposés sur un cylindre sont parcourus par un courant correspondant à un champ magnétique homogène dans le volume qu'il circonscrivent, caractérisé en ce que le cylindre est non circulaire, ledit dispositif comportant des moyens pour faire par courir dans les conducteurs un courant dont l'intensité est une fonction trigonométrique p cos θ des coordonnées polaires de chacun de ces conducteurs par rapport à un système d'axes de référence orthogonal aux conducteurs.

L'invention concerne également un dispositif de création et/ou de réception d'un champ magnétique alternatif pour appareil exploitant la résonance magnétique nucléaire dans lequel des conducteurs sensiblement parallèles sont parcourus par un courant correspondant à un champ magnétique homogène dans le volume qu'ils circonscrivent caractérisé en ce qu'il comporte des moyens pour produire des rotations entre les phases des différents courants pour correspondre à un champ magnétique tournant.

L'invention sera mieux comprise à la lecture de la description qui suit et à l'examen des figures qui l'accompagnent. Cette description est donnée à titre indicatif et nullement limitatif de l'invention. Sur les figures les mêmes repères désignent les mêmes élémentes. Elles représentent:

—figures 1a et 1b: un répartition particulière des fils conducteurs sur un cylindre circulaire,

—figures 1c et 1d: une variante préférée de la répartition selon l'invention,

—figure 2: un schéma d'un circuit d'alimentation particulier conforme à l'invention;

—figure 3a à 3c: une variante du circuit d'alimentation de la figure précédente;

—figure 4: un circuit d'alimentation des fils conducteurs propre à créer un champ tournant.

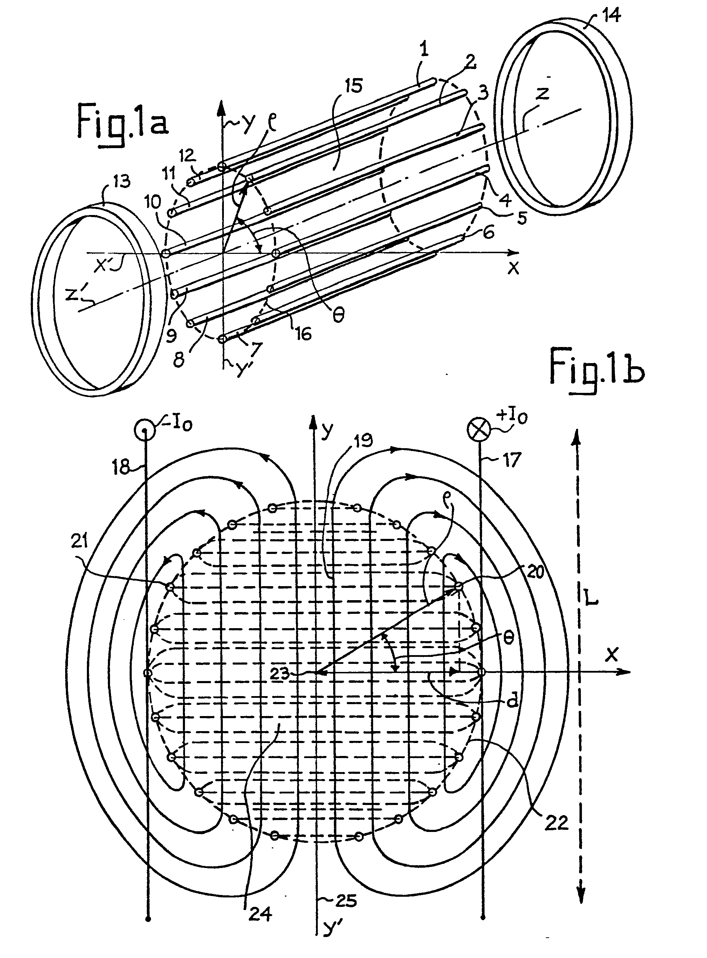

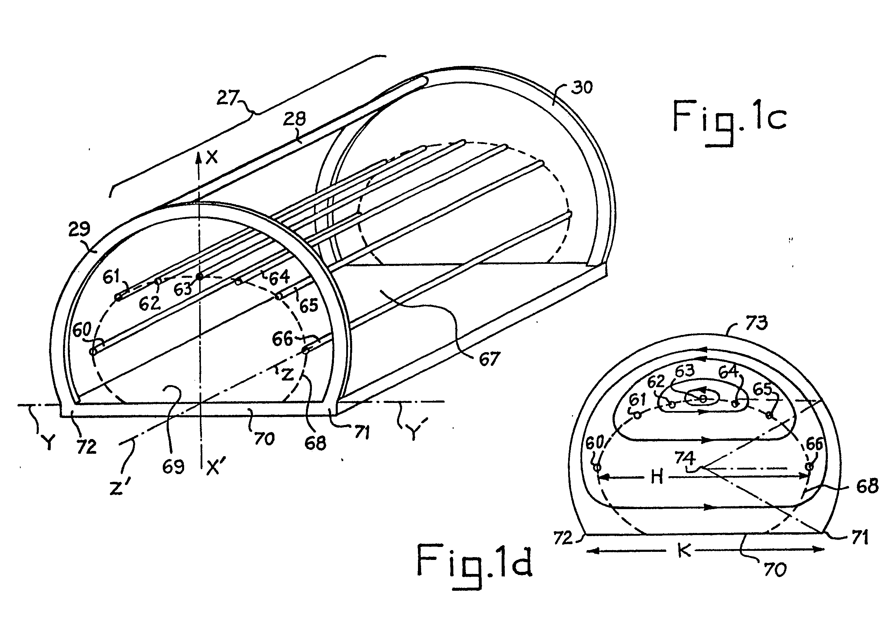

La figure 1a représente en perspective une structure de fils conducteurs numérotés de 1 à 12. Ces conducteurs sont sensiblement parallèles entre eux et à un axe Z'Z. L'axe Z'Z est l'axe du champ orientateur $B_0$ d'un appareil exploitant la résonance magnétique nucléaire. Cet appareil est représenté symboliquement par ses deux bobines de champ orientateur 13 et 14. Il comporte par ailleurs des ensembles non représentés, par ce que bien connus et indépendants de l'invention, de bobines de gradient ainsi qu'un ensemble général de circuits d'émission-réception et traitement de signal. L'axe Z'Z est perpendiculaire à un système d'axes de référence X'X et Y'Y. Par rapport à ce système d'axes chacun des conducteurs est repéré par ses coordonnées polaires p et θ. Ce qui caractérise l'invention c'est que, pour produire un champ magnétique alternatif homogène à l'intérieur du volume circonscrit par les conducteurs, l'intensité du courant électrique qui par court ces conducteurs est une fonction trigonométrique de leurs coordonnées polaires. Autrement dit, dans chaque conducteur passe un courant particulier. Dans le cas où le volume 15 circonscrit par les conducteurs est un cylindre circulaire dont les génératrices s'appuient sur un cercle 16 la fonction trigonométrique est $I_0 \cos \theta$. Dans ce cas particulièrement simple, eu égard à l'homogénéité, l'intensité est même indépendante du module p de repérage de chacun des conducteurs.

La figure 1b, vue en coupe selon un plan parallèle à X'X—Y'Y permet de donner une explication simple de ce phénomène. Considérons deux plaques parallèles 17 et 18 de largeur L parcourues respectivement par un courant $+I_0$ et $-I_0$. Les courants $\pm I_0$ sont uniformément répartis dans la section de chaque plaque; le premier s'éloigne de l'observateur (trace d'empennage de flèche) le second se rapproche de l'observateur (trace de pointe de flèche). Le champ électrique produit entre les plaques est perpendiculaire à leur surface. Sur cette figure les lignes de champ électrique sont représentées en tirets et les lignes de champ magnétique en traits pleins. Le champ magnétique, en tous points perpendiculaire au champ électrique ainsi qu'aux courants $\pm I_0$, comporte des segments de lignes de champ tels que 19 qui sont rectilignes. Pour une dimension donnée de la largeur L il est possible de déterminer un volume, relativement petit par rapport à la largeur L, pour lequel tous les segments rectilignes de champ magnétique sont parallèles entre eux et correspondent à un champ d'égale intensité. Ce champ magnétique est alors parfaitement homogène puisque le champ électrique entre les plaques est uniforme.

Le principe à la base de l'invention consiste à emplacer les deux plaques 17 et 18 par un ensemble de fils conducteurs tels que 20 et 21 suffisamment proches les uns des autres. Ces conducteurs doivent être parcourus chacun par un courant d'intensité convenable pour reproduire le même état de champ électrique uniforme. En conséquence un même état de champ magnétique homogène sera également reproduit. L'intensité convenable qui parcourt chacun des conducteurs est liée aux coordonnées de l'endroit où ces conducteurs coupent un contour 22. Les coordonnées des points du contour 22 sont repérées par rapport au centre 23 de la section 24 du volume où l'on cherche à produire le champ magnétique homogène. Pour obtenir un champ électrique donné entre deux conducteurs appairés (20, 21), il convient de régler la différence de potentiel qui règne entre ces deux conducteurs au prorata de la distance qui les sépare. Ou encore, considérant chaque conducteur isolément, il convient de rendre cette différence de potentiel proportionnelle à la distance $d$ qui sépare de conducteur d'un plan moyen 25 sécant à la section 24. Eu égard au centre 23, cette distance $d$ est égale à $p \cos \theta$. Donc la différence de potentiel doit être dépendante de $p \cos \theta$. A résistance égale de tous les conducteurs, le courant qui circule dans chacun des conducteurs doit alors être fonction de $p \cos \theta$: c'est-à-dire une fonction trigonométrique du repérage de ce conducteur.

Dans une réalisation particulière le contour 22 est un cercle: le cercle 16 de la figure 1a; les conducteurs sont régulièrement répartis sur le pourtour du volume cylindrique 15; ils sont placés symétriquement les uns des autres par rapport au plan 25 correspondant au plan Y'Y—Z'Z. Dans l'exemple représenté où le nombre des conducteurs est de 12, la différence d'angle au centre qui repère deux conducteurs adjacents vaut 30°. Dans ces conditions on obtient un défaut d'homogénéité de l'ordre de 1% dans un volume réduit de 50% par rapport au volume du cylindre. La zone d'homogénéité à 10% se trouve alors augmentée sensiblement de 50% par rapport au cas précédent. L'homogénéité peut encore être augmentée en augmentant le nombre des conducteurs. Cependant, d'autres dispositions que cylindriques circulaires peuvent être retenues pour le volume 15. Ce qui est important c'est de créer un champ électrique uniforme entre tous les conducteurs de manière à créer un champ magnétique correspondant homogène. Dans ce cas le courant dans chaque conducteur est de type $I_0 \rho \cos \theta$.

Les figures 1c et 1d représentent une variante préférée de réalisation de la structure des conducteurs. Sur celles-ci un ensemble de conducteurs numérotés 60 à 66 circonscrivent un cylindre 67 s'appuyant, en partie, sur un contour 68. Le cylindre 67 comporte de plus une face plane 69. La face 69 est matérialisée par la surface d'un plateau métallique 70. Ce plateau 70 est le plateau porte patient de l'appareil de résonance magnétique nucléaire. Ce plateau se trouve à l'endroit du plan 25 de la figure 1b. La présence de ce plateau métallique se justifie dans la mesure où on réalise ainsi une surface équipotentielle. On place cette surface équipotentielle dans le champ électrique décrit par la figure 1b, de telle façon qu'il ne perturbe pas ce champ. On s'affranchit alors de la nécessité de créer le champ électrique dans le volume masqué par ce plateau et ceci rend inutile l'existence d'un jeu symétrique des conducteurs. En effet le courant de retour s'effectue par le plateau lui-même. La présence d'une face métallique plane impose une surface équipotentielle, donc un champ électrique uniforme perpendiculaire à cette surface et par conséquent un champ magnétique homogène parallèle à cette surface. Cette variante, qui intègre bien dans le dispositif d'excitation la présence du plateau porte patient, montre la variété des solutions possible pour les contours sur lesquels s'appuient les génératrices du cylindre.

Pour des raisons qui seront expliquées plus loin le cylindre 67 est contenu dans une cage de Faraday 27. La cage 27 comporte essentiellement deux arceaux métalliques 29 et 30 reliés entre eux par un jeu de barres métalliques telles que 28. Les arceaux reposent par ailleurs à leurs bases sur les bords 71 et 72 du plateau 70. Le plateau fait partie intégrante de cette cage de Faraday: il la ferme. La figure 1d montre, en coupe selon un plan XY, le dispositif de la figure 1c. La cage 27 y a un profil en forme de portion de cercle 73 centré en 74. Le plateau 70 constitue le corde d'un arc de cercle dont l'angle au centre vaut environ 120°: angle 72—74—71. Les conducteurs sont répartis sur le contour 68 qui a sensiblement la forme d'une ellipse dont le grand axe, parallèle au plateau 70, passe par le centre 74. Le grand diamètre H de cette ellipse est inférieur à la largeur K du plateau. Les conducteurs 60 et 66 les plus proches du plateau 70, passent sensiblement dans le plan du grand axe du contour 68. Le petit diamètre de l'ellipse est sensiblement égal au double de la distance qui sépare le centre 74 du plateau 70. Dans ces conditions le courant qui passe dans chacun de ces conducteurs a une intensité sensiblement la moitié de celle qui passe dans le conducteur 63 le plus éloigé du plateau.

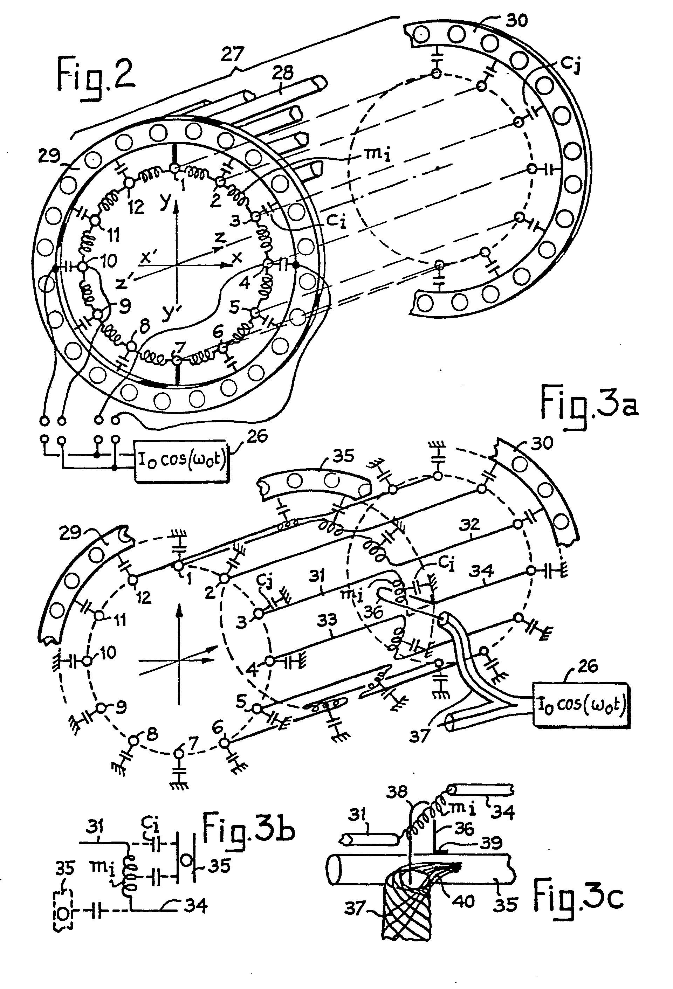

La figure 2 représente un dispositif d'alimentation électrique des conducteurs de la figure 1a. Un dispositif d'alimentation similaire peut être mis en oeuvre pour les conducteurs de la figure 1c. On a vu précédemment que chaque conducteur devait être alimenté par une source de courant dont l'intensité est une fonction des coordonnées polaires des fils par rapport à un système d'axe de référence. Il faut bien entendu que toutes ces sources de courant soient en phase par rapport à la fréquence d'oscillation du champ magnétique alternatif ainsi créé. Dans un circuit d'alimentation en tension décrit par la figure 2 cette alimentation est obtenue au moyen d'un seul générateur: le générateur 26. Une des particularités supplémentaires de l'invention consiste à remarquer que la variation de l'intensité en fonction du repérage du conducteur peut être obtenue simplement en alimentant ces conducteurs au moyen d'une ligne hyperfréquence. On sait que l'amplitude de l'onde créée dans la ligne est fonction des coordonnées de chaque point de la ligne par rapport à l'origine de cette ligne.

En effet, cette amplitude $A_1$ est une fonction du cosinus du rapport de l'abscisse $l$ d'un point considéré à la longueur d'onde. Ceci peut s'écrire:

$$A_1 = A_0 \cos \left(2\pi \cdot \frac{l}{\lambda}\right)$$

où $l$ repère la distance qui sépare un point de la ligne de l'origine de cette ligne. Cette formule n'est valable bien entendu que si la ligne est une ligne désadaptée et que si donc son taux d'onde stationnaire est infini. Dans le circuit d'alimentation de la figure 2 la ligne est enroulée autour du cercle 16. La longueur d'onde dont il est question est déterminée d'une part par la fréquence de l'onde alternative considérée et d'autre part par la vitesse de propagation de cette onde dans la ligne. Aux fréquences considérées, comprises entre 6 et 80 MHz, la longueur d'onde dans le vide ou dans l'air est comprise entre 50 m et 3,75 m. Par contre, la circonférence du cercle 16 est généralement de l'ordre de 2 m. En effet, le diamètre de ce cercle vaut environ 0,6 m: il est calculé pour pouvoir y introduire le corps d'un patient.

Deux solutions sont alors envisageables. Une première solution, utilisant les conditions de propagation des ondes électriques dans le vide, consistera à faire onduler une ligne hyperfréquence bifilaire, par exemple coaxiale, de longueur adaptée à la longueur d'onde dans le vide, de manière à ce que la base des ondulations soit projetée sur le cercle 16 à l'endroit du raccordement des fils conducteurs. Une deuxième solution consiste à réaliser un ligne hyperfréquence à constantes localisées. Cette solution qui est la solution préférée est représentée sur la figure 2.

Pour la réalisation de la ligne hyperfréquence on met à profit l'existence d'une cage de Faraday 27 qui est normalement réalisée autour de l'ensemble des conducteurs d'excitation. L'existence de la cage de Faraday 27 est imposée par la nécessité d'empêcher le champ d'excitation de venir perturber le fonctionnement des bobines de champ orientateur ainsi que des bobines de gradient. La cage de Faraday est réalisée à claire voie de manière, par contre, à laisser pénétrer ces champs orientateurs ou de gradient jusque dans le volume 15. Dans un exemple de réalisation cette cage de Faraday est réalisée, comme la structure d'excitation, au moyen de barres métalliques telles que 28 raccordées entre elles à chaque extrémité par deux couronnes 29 et 30 coaxiales au cylindre 15. Le diamètre de ces couronnes est légèrement supérieur au diamètre du cercle 16. Dans un exemple le nombre des barres 28 est égal au double du nombre des conducteurs. L'espace qui sépare les couronnes du cercle 16 est sensiblement égal à la moitié de la distance qui sépare deux conducteurs adjacents sur le cylindre.

La ligne hyperfréquence d'alimentation est constituée d'une part de la couronne 29 et d'autre part d'un ensemble de cellules inductance-capacité $m_i$—$c_i$). Les inductances $m_i$ sont placées sur le cercle 16 perpendiculairement aux génératrices du cylindre. Les capacités $c_i$ relient radialement chaque conducteur à la couronne 29. Le calcul de ces conductances et de ces capacités est donné par les équations suivantes:

$$Z_c=\sqrt{M/C};\ MC\,v^2=1;\ et\ \frac{1}{fo}\cdot v=\lambda.$$

Dans ces formules, $Z_c$ est l'impédance caractéristique de la ligne égale à l'impédance de sortie du générateur 26, M et C sont les inductances et les capacités apparentes de la ligne, $v$ est la vitesse de phase ou vitesse de propagation de l'onde dans la ligne, $f_o$ est la fréquence de l'onde alternative, et $\lambda$ est la longueur d'onde réelle créée. En définitive, pour que l'onde se propage d'un point de la ligne à l'autre, compte tenu du fait que la longueur de cette ligne est imposée (elle est égale à la circonférence du cercle 16) c'est la vitesse de phase de l'onde créée qui doit être adaptée. Autrement dit, connaissant $\lambda$ qui est égal à la circonférence du cercle 16 on en déduit une vitesse de phase $v$. Connaissant par ailleurs l'impédance caractéristique du générateur 26 on peut calculer alors M et C. On déduit les valeurs de $m_i$ et de $c_i$ de ces valeurs de M et C et du nombre de conducteurs que l'on désire mettre en place.

Les conducteurs sont reliés à une de leurs extrémités aux cellules $m_i$—$C_i$; au point de connexion de l'inductance et de la capacité. A leur autre extrémité ils sont reliés à la couronne 30 par des capacités $c_j$. La présence des capacités $c_j$ a pour objet d'accorder les lignes représentées par les conducteurs de manière à les faire résonner. Les capacités $c_j$ sont déterminées par la longueur des conducteurs relativement à la longueur d'onde dans le vide de l'onde d'excitation. La longueur des conducteurs doit être inférieure à la moitié de cette longueur d'onde dans le vide.

De manière à ce que les conducteurs situés à droite du plan Y'Y—Z'Z soient parcourus par un courant en opposition de phase (cosinus $\pi-\theta=-$cosinus $\theta$) la ligne est alimentée en opposition de phase en deux points diamètralement opposés. La ligne se compose alors de quatre éléments quart d'onde: un premier élément entre le conducteur 1 et le conducteur 4, un deuxième élément entre le conducteur 4 et le conducteur 7, un troisième élément entre le conducteur 7 et le conducteur 10, et un quatrième élément entre le conducteur 10 et le conducteur 1. L'alimentation en tension est appliquée aux bornes de la ligne, en opposition de phase, entre le conducteur 4 et la couronne 29 d'une part et entre le conducteur 10 et la couronne 29 d'autre part. Les conducteurs 1 et 7, à leur extrémité connectée à la ligne sont court-circuités à la couronne 29. Ces court-circuits assurent un noeud de tension en ces points par rapport aux ventres de tension qui existent aux points d'alimentation. Dans ces conditions on se retrouve avec des conducteurs appairés, les paires 2—12, 3—11, 4—10, 5—9, et 6—8. Les conducteurs 1 et 7 sont "appairés" avec eux-mêmes. On constate que les courants dans chacun des conducteurs appairés sont égaux entre eux mais de signes contraires. Les courants dans les conducteurs 8 à 12 sont en permanence de sens inverse au courant dans les conducteurs 2 à 6. Les intensités de ces courants suivent la loi $I_0$ cos $\theta$. Il en résulte le champ homogène attendu au sein du volume 15 circonscrit par les conducteurs.

Dans la variante décrité plus haut il n'y a qu'une seule phase à alimenter. L'alimentation peut se faire ici aussi avec une ligne hyperfréquence. L'alimentation se fait entre le conducteur 63 (voir figure 1c) et la couronne 29. Les noeuds de tension sont assurés en raccordant les bords 71 et 72 du plateau à la couronne 29. L'avantage qui résulte de n'alimenter qu'une phase consiste à n'avoir à accorder qu'un seul jeu de capacités $c_j$ puisqu'il n'y a plus qu'un jeu de conducteurs.

Les figures 3a à 3c représentent un autre mode d'alimentation des conducteurs. Il s'agit d'une alimentation en courant duale de l'alimentation en tension de la figure 2. La ligne hyperfréquence d'alimentation est réalisée dans les mêmes conditions et à partir des mêmes équations de base. La structure des conducteurs est légèrement différente: chaque conducteur est constitué de deux segments. Ainsi, par exemple le conducteur 3 comporte un segment 31 et un segment 32. De même le conducteur 4 comporte un segment 33 et un segment 34, etc. Dans une réalisation préférée le inductances $m_i$ sont disposées sensiblement au milieu des conducteurs. Elles sont raccordées par un pôle à une extrémité d'un segment d'un conducteur et par leur autre pôle à une extrémité d'un segment complémentaire d'un conducteur adjacent. Comme l'indique la figure 3b, les capacités $c_i$ sont raccordées d'une part à une troisième couronne circulaire 35 et d'autre part à l'une des extrémités de l'inductance $m_i$ ou éventuellement même au point milieu de celle-ci. La couronne 35 est placée à mi-hauteur du cylindre et donc à mi-longueur des conducteurs. Ces raccordements des capacités $c_i$ sont équivalents. Ils reviennent à remplacer les cellules $m_i$—$c_i$ en π par des cellules $m_i$—$c_i$ en T. L'alimentation est appliquée à la ligne par couplage inductif du champ créé par une boucle de l'âme 36 d'un câble coaxial 37. La figure 3c représente ce couplage inductif. L'âme 36 forme une boucle 38 induisant l'onde d'excitation dans la bobine $m_i$. L'extrémité 39 de l'âme 36 est connectée, après la boucle, à la couronne 35. De même la tresse 40 du câble 37 est également connectée à la couronne 35. L'avantage procuré par cette alimentation par couplage réside dans la simplicité qu'il y a à alimenter les conducteurs en phase ou en opposition de phase. D'une situation à l'autre il suffit d'inverser le sens s'enroulement de la boucle 38 autour de l'inductance $m_i$ pour changer la polarité du courant qui circule dans les conducteurs.

L'alimentation en courant par la boucle 38 simplifie les modes de raccordement du générateur 26 puisqu'il n'est plus nécessaire de disposer de symétriseurs pour attaquer deux points de la ligne en opposition de phase. Il est utile de remarquer que dans la figure 3a comme dans la figure 2 il existe un deuxième point d'alimentation diamétralement opposé à celui décrit. Ce deuxième point n'est pas représenté ici pour ne pas surcharger le dessin.

Un autre avantage de l'alimentation en courant par rapport à l'alimentation en tension de la figure 2 réside dans le fait qu'à l'endroit de la couronne 35 on détermine un ventre de courant puisque l'alimentation est en courant. En conséquence, à l'endroit de la couronne 35 il y a un noeud de tension donc un champ électrique nul. Le champ électrique est dont inversé à l'endroit de la couronne 29 par rapport au champ électrique à l'endroit de la couronne 30. En conséquence, les intensités de ces deux champs électriques sont inférieures de moitié au champ électrique au droit de la couronne 29 de la figure 2. Ce qui diffère encore de la structure de la figure 2 c'est que tous les segments de conducteurs sont reliés, à leur extrémité qui n'est pas reliée aux inductances $m_i$, aux couronnes 29 et 30 part des capacités de résonance $c_j$. Dans la réalisation préférée, les segments complémentaires d'un conducteur sont de longueur égale. Ceci n'est cependant nullement une obligation mais se réfère à la réduction du champ électrique dans le corps examiné. L'alimentation en courant est tout à fait applicable à la variante préférée. Les conducteurs 60 à 66 de celle-ci prennent la place des conducteurs 1 à 7 de la figure 3a: il n'y a plus qu'une seule alimentation.

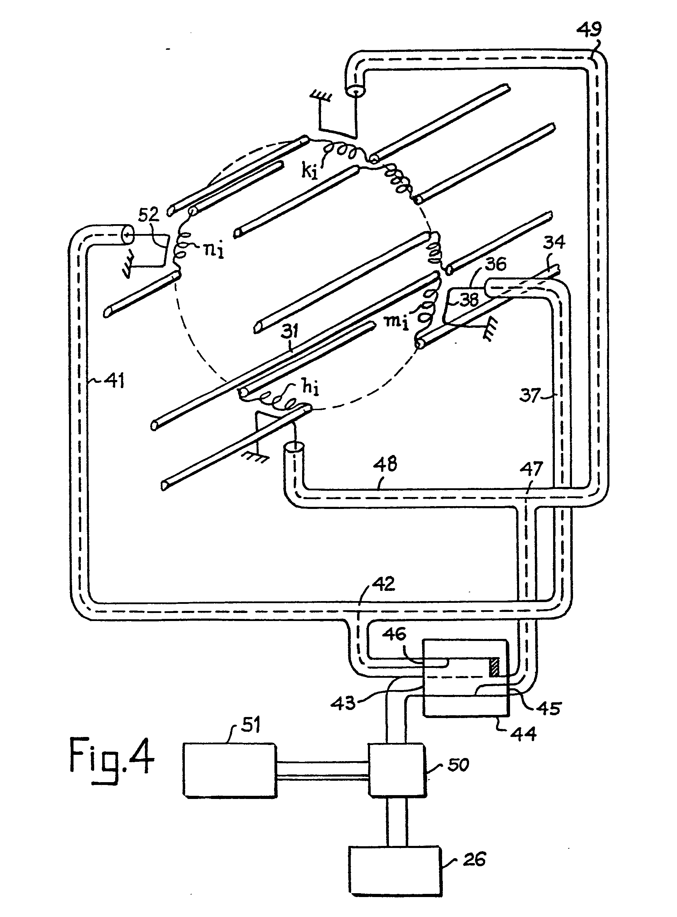

La figure 4 représente un ensemble de moyens aptes à créer un champ d'excitation tournant. Elle est une figure simplifiée de la figure 3a. On y distingue en particulier l'alimentation par couplage de l'inductance $m_i$ raccordée de part et d'autre aux segments de conducteurs 31 et 34. Elle comporte également comme il a été évoqué précédemment un couplage d'une inductance $n_i$

diamétralement opposée à l'inductance $m_i$. On remarquera que les deux couplages à partir du câble coaxial 37 d'une part et à partir d'un câble coaxial 41 d'autre part, émanant tous deux d'une dérivation 42, sont réalisés en opposition de phase: les boucles 38 et 52 des âmes de ces câbles coaxiaux étant d'orientation inversée. Ce qui caractérise la création d'un champ tournant dans l'invention c'est que les conducteurs sont alimentés avec une phase variable dépendant de leur position repérée sur le cylindre.

Ainsi le générateur 26 est raccordé à une entrée 43 d'un coupleur à 3 dB. Le coupleur 44 comporte deux sorties respectivement 45 et 46. On sait que les deux sorties d'un tel coupleur présentent l'une par rapport à l'autre un déphasage de 90°. Les ondes qui en émergent sont donc en quadrature de phase. Elles sont par ailleurs d'égale intensité. L'onde qui émerge de la sortie 46 est dirigée vers le dérivateur 42 pour alimenter les deux inductances $n_i$ et $m_i$. L'onde qui sort de la sortie 45 est dirigée vers un dérivateur 47 qui alimente par des câbles coaxiaux 48 et 49, selon des dispositions similaires, deux inductances $h_i$ et $k_i$ diamétralement opposées l'une de l'autre et disposées à angle droit de l'alignement des inductances $n_i$—$m_i$. Du fait de la structure parfaitement symétrique circulaire de la structure d'excitation de la figure 3a ceci revient à faire parcourir dans chaque conducteur un courant dont l'intensité est donnée par:

$$I=I_o \cos (2\pi f_o t+\theta)$$

L'intensité du courant dans chaque conducteur vaut alors $I_0$: la phase du courant dans chaque conducteur est égale à l'angle de repère du conducteur. On peut montrer que cette distribution des courants est de nature à produire un champ tournant d'intensité proportionnelle à $I_0$ et dont la vitesse de rotation dans l'espace correspond à la fréquence du champ alternatif. Bien entendu les décalages de phase sont agencés de manière à faire tourner le champ dans le sens convenable par rapport au sens de précession des moments magnétiques des noyaux.

Dans la réalisation décrite la ligne est alimentée en quatre points. Il est cependant possible de d'alimenter en N points en déphasant les sources les unes par rapport aux autres successivement d'une quantité de 2 π/N. La réalisation représentée sur la figure 4 présente l'avantage d'être propice à l'excitation d'un champ tournant et par ailleurs d'être adaptée à la réception d'un tel champ. En effet, après la phase d'excitation des noyaux, pour la mesure du signal de retour des noyaux à la précession libre, on utilise la même structure comportant la ligne hyperfréquence, les circuits de couplage des âmes des câbles coaxiaux, les dérivateurs, et le coupleur à 3 db. On interpose cependant entre le coupleur 44 et le générateur 26 un duplexeur 50 qui oriente les signaux reçus vers un récepteur 51. Ce récepteur 51 représente symboliquement tous les traitements effectués sur ces signaux en vue de la mise en évidence de l'information qu'ils contiennent. En définitive, le signal qui sort du duplexeur 50 à destination du récepteur 51 est d'intensité deux fois plus élevée qui celui que l'on aurait reçu si le dispositif d'excitation n'avait pas comporté des moyens pour créer un champ tournant.

Les moyens pour créer un champ tournant qui sont décrits ici comme un perfectionnement des moyens pour créer un champ alternatif homogène peuvent cependant être employés indépendamment de toutes considérations d'homogénéité. En particulier dans des applications où l'on cherche plutôt une réponse en volume du corps étudié, l'homogénéité peut être négligée au profit d'un gain de 3 dB à la réception. Ainsi, une structure à trois conducteurs alimentés avec des décalages de phase respectivement de $2\pi/3$, et répartis au sommet d'un triangle équilatéral est équivalente à un couple de conducteurs parallèles tournant autour d'un axe situé au milieu de ces deux conducteurs. Dans ces conditions le champ ne serait pas très homogène par contre il serait tournant. Dans cette réalisation on continuerait à utiliser un générateur unique et chacun des trois conducteurs serait alimenté après passage du signal d'excitation dans un premier puis dans un deuxième déphaseur de $2\pi/3$.

## Revendications

1. Dispositif de création et/ou de réception d'un champ magnétique (19) alternatif pour appareil (13, 14) exploitant la résonance magnétique nucléaire dans lequel des fils conducteurs (1—12) sensiblement parallèles sont disposés sur un cylindre et sont parcourus par un courant (26) correspondant à un champ magnétique homogène dans le volume (15) qu'ils circonscrivent, caractérisé en ce que le cylindre est non circulaire, ledit dispositif comportant des moyens ($m_i$, $c_i$) pour faire parcourir dans les conducteurs un courant dont l'intensité est une fonction trigonométrique $\rho \cos \theta$ des coordonnées polaires de chacun de ces conducteurs par rapport à un système (X'X, Y'Y) d'axes de référence orthogonal aux conducteurs.

2. Dispositif selon la revendication 1 caractérisé en ce que les conducteurs sont répartis sur la surface d'un cylindre (67) comportant une face plane (69) métallique (70) pour servir de plateau porte-patient à l'appareil.

3. Dispositif selon la revendication 1 ou la revendication 2 caractérisé en ce que les moyens d'alimentation électrique comporte une ligne hyperfréquence ($m_i$, $c_i$, 29) orthogonale aux conducteurs et vehiculant une onde dont la vitesse de phase (v) est adaptée à la longueur ($\lambda$) d'un contour (22) sur lequel s'appuient les conducteurs (1—12).

4. Dispositif selon la revendication 2 ou la revendication 3 caractérisé en ce que les moyens d'alimentation électrique comportent une ligne hyperfréquence à constantes localisées ($m_i$, $c_i$) et vehiculant une onde dont la vitesse de phase (v) détermine une longueur d'onde ($\lambda$) égale au périmètre du contour (16) sur lequel s'appuient les génératrices du cylindre (15) et en ce que cette ligne est alimentée en au moins un premier (4—29) endroit et est court-circuitée en deux deuxièmes (1—29, 7—29) endroits diamétralement opposés et disposés à angle droit du premier endroit.

5. Dispositif selon l'une quelconque des revendications 1 à 3 caractérisé en ce que les moyens d'alimentation électrique comportent une ligne hyperfréquence (35) déployée sur le contour sur lequel s'appuie le cylindre qui enferme le volume circonscrit, à constantes localisées ($m_i$), et véhiculant une onde dont la vitesse de phase détermine une longueur d'onde correspondant ($\lambda/2$) à la longueur de ce contour, et en ce que cette ligne comporte un ensemble de bobines d'induction ($m_i$) insérées en série entre deux segments (31, 34) complémentaires de deux conducteurs adjacents et en ce que cette ligne est alimentée (37) en au moins un troisième (31, 34) endroit.

6. Dispositif selon la revendication 5 caractérisé en ce que le troisième endroit est situé à mi-hauteur du cylindre.

7. Dispositif selon l'une quelconque des revendication 3 à 6 caractérisé en ce que les lignes sont constituées de cellules en T.

8. Dispositif selon l'une quelconque des revendications 3 à 6 caractérisé en ce que les lignes sont constituées de cellules en $\pi$.

9. Dispositif selon l'une quelconque des revendications 1 à 8, caractérisé en ce que l'ensemble de fils conducteurs est contenu dans une cage (27) de Faraday et en ce que les extrémités des fils conducteurs sont reliés à cette cage par des capacités ($c_i$).

10. Dispositif selon l'une quelconque des revendications 3 à 9 caractérisé en ce que le circuit d'alimentation de la ligne comporte des câbles coaxiaux (37) dont l'âme (36) d'une extrémité est couplée (38) magnétiquement à la ligne et dont la tresse (40) de blindage est raccordée électriquement à la ligne.

11. Dispositif selon l'une quelconque des revendications 3 à 10 caractérisé en ce qu'il comporte des moyens (44) de rotation de phase pour alimenter différents endroits ($h_i$, $k_i$, $m_i$, $n_i$) de la ligne avec des phases décalées d'une manière à produire un champ magnétique d'excitation qui soit tournant ($2\pi f_o$).

12. Dispositif selon les revendications 11 et 5 caractérisé en ce que la ligne est alimentée en deux quatrièmes ($h_i$, $k_i$) endroits respectivement en quadrature de phase par rapport à deux troisièmes ($m_i$, $n_i$) endroits.

13. Dispositif selon les revendications 11 et 12, caractérisé en ce que des rotations de phase de $\pi/2$ sont obtenues en insérant un coupleur (44) directif dans une voie d'alimentation et en séparant (42, 47) chacune des deux voies (37, 41, 48, 49) de sortie du coupleur en deux voies en opposition de phase.

14. Dispositif selon l'une quelconque des revendications 1 à 13 caractérisé en ce qu'il comporte des moyens (70) pour créer une surface (69) équipotentielle et en ce que la fonction trigonométrique qui module l'intensité dans chaque conducteur est proportionnelle à la distance $\rho \cos \theta$ qui sépare chaque conducteur de cette surface équipotentielle.

**Patentansprüche**

1. Vorrichtung zur Erzeugung und/oder zum Empfang eines magnetischen Wechselfeldes (19) für mit magnetischer Kernresonanz arbeitende Geräte (13, 14), in der etwa parallele Leitungsdrähte (1, 12) auf einem Zylinder angeordnet sind und von einem Strom (26) durchflossen werden, der einem homogenen magnetischen Feld in dem Volumen (15) entspricht, das sie umschreiben, dadurch gekennzeichnet, daß der Zylinder nicht kreisförmig ist und die betreffende Vorrichtung Mittel $(m_i, c_i)$ umfaßt, damit in den Leitern ein Strom fließen kann, dessen Stärke eine trigono-metrische Funktion $\rho \cos \theta$ der Polkoodinaten eines jeden dieser Leiter im Verhältnis zu einem System (X'X, Y'Y) von Bezugsachsen ist, die orthogonal zu den Leitern liegen.

2. Vorrichtung nach Anspruch 1, dadurch gekennzeichnet, daß die Leiter auf der Oberfläche eines Zylinders (67) verteilt angeordnet sind, der eine ebene Fläche (69) aus Metall (70) umfaßt, um den Gerät als Trägerplatte für den Patienten zu dienen.

3. Vorrichtung nach Anspruch 1 oder nach Anspruch 2, dadurch gekennzeichnet, daß die Mittel für die elektrische Stromversorgung eine Ultrahochfrequenzleitung $(m_i, c_i, 29)$ umfassen, die orthogonal zu den Leitern liegt und eine Welle befördert, deren Phasengeschwindigkeit (v) der Länge ($\lambda$) eines Umfangs (22) angepaßt ist, auf dem die Leiter (1—12) aufliegen.

4. Vorrichtung nach Anspruch 2 oder Anspruch 3, dadurch gekennzeichnet, daß die Mittel der elektrischen Stromversorgung eine Ultrahochfrequenzleitung mit festgelegten Konstanten $(m_i, c_i)$ umfassen, auf der eine Welle befördert wird, deren Phasengeschwindigkeit (v) eine Wellen-länge ($\lambda$) festlegt, die gleich dem Umfang (16) ist, auf dem die Mantellinien des Zylinders (15) aufliegen, und dadurch, daß diese Leitung wenigstens an einer ersten Stelle (4—29) mit Strom versorgt wird und an zwei weiteren Stellen (1—29, 7—29), die diametral entgegengesetzt und im rechten Winkel zur ersten Stelle angeordnet sind, kurzgeschlossen ist.

5. Vorrichtung nach einem der Ansprüche 1 bis 3, dadurch gekennzeichnet, daß die Mittel der elektrischen Stromversorgung eine Ultrahochfrequenzleitung (35) umfassen, die um den Umfang gelegt ist, auf dem der Zylinder aufliegt, der das Volumen umschließt, mit festgelegten Konstan-ten $(m_i)$ und eine Welle befördernd, deren Pha-sengeschwindigkeit eine Wellenlänge ($\lambda/2$) fest-legt, die der Länge dieses Umfangs entspricht, und dadurch, daß diese Leitung einen Satz Induk-tionsspulen $(m_i)$ umfaßt, die zwischen zwei Segmenten (31, 34) in Serie geschaltet sind, die zu zwei angrenzenden Leitern komplementär sind, und dadurch, daß diese Leitung zumindest an einer dritten Stelle (31, 34) mit Strom versorgt wird (37).

6. Vorrichtung nach Anspruch 5, dadurch gekennzeichnet, daß sich die dritte Stelle auf halber Höhe des Zylinders befindet.

7. Vorrichtung nach einem der Ansprüche 3 bis 6, dadurch gekennzeichnet, daß die Leitungen aus T-förmigen Zellen bestehen.

8. Vorrichtung nach einem der Ansprüche 3 bis 6, dadurch gekennzeichnet, daß die Leitungen aus π-förmigen Zellen bestehen.

9. Vorrichtung nach einem der Ansprüche 1 bis 8, dadurch gekennzeichnet, daß die gesamten Leitungsdrähte in einem Faradayschen Käfig (27) untergebracht sind, und dadurch, daß die äußersten Enden der Leitungsdrähte mit diesem Käfig durch Kapazitäten $(c_j)$ verbunden sind.

10. Vorrichtung nach einem der Ansprüche 3 bis 9, dadurch gekennzeichnet, daß der Stromversorgungskreis der Leitung Koaxialkabel (37) umfaßt, deren Kabelseele (36) an einem Ende mit der Leitung magnetische gekoppelt (38) ist und deren Abschirmgeflecht (40) mit der Leitung elektrisch verbunden ist.

11. Vorrichtung nach einem der Ansprüche 3 bis 10, dadurch gekennzeichnet, daß sie Mittel (44) der Phasendrehung zur Stromversorgung verschiedener Stellen $(h_i, k_i, m_i, n_i)$ der Leitung umfaßt, und zwar mit so verschobenen Phasen, daß ein rotierendes $(2\pi f_o)$ magnetisches Erreger-feld erzeugt wird.

12. Vorrichtung nach den Ansprüchen 11 und 5, dadurch gekennzeichnet, daß die Leitung in zwei vierten $(h_i, k_i)$ Stellen bzw. im Verhältnis zu zwei dritten $(m_i, n_i)$ Stellen um 90° phasenverschoben gespeist wird.

13. Vorrichtung nach den Ansprüchen 11 und 12, dadurch gekennzeichnet, daß Phasendrehun-gen von π/2 dadurch erzielt werden, daß ein Richtkoppler (44) in einen Stromversorgungskanal geschaltet wird, und daß jeder der beiden Ausgangskanäle (37, 41, 48, 49) des Richtkopplers in zwei gegenphasige Kanäle getrennt (42, 47) wird.

14. Vorrichtung nach einem der Ansprüche 1 bis 13, dadurch gekennzeichnet, daß sie Mittel (70) zur Erzeugung einer Äquipotentialfläche (69) umfaßt, und dadurch, daß die trigonometrische Funktion, welche die Stromstärke in jedem Leiter moduliert, proportional dem Abstand $\rho \cos \theta$ ist, der jeden Leiter von dieser Äquipotentialfläche trennt.

**Claims**

1. A device for creating and/or receiving an alternating magnetic field (19) for an apparatus (13 and 14) utilizing nuclear magnetic resonance in which substantially parallel conductor wires (1—12) are placed on a cylinder and have a current (26) through them which corresponds to a magnetic field which is homogeneous in the volume (15) which they delimit, characterized in that the cylinder is non-circular and the said device comprises means ($m_i$ and $c_i$) in order to produce a current in the conductors such that the intensity of the current is a trigonometrical function $\rho \cos \theta$ of the polar coordinates of each of the conductors in response to a system (X'X and Y'Y) of reference axes which are orthogonal in relation to the conductors.

2. The device as claimed in claim 1, characterized in that the conductors are distributed over the surface of a cylinder (67) comprising a planar metallic (70) face (69) in order to serve as the patient support table of the apparatus.

3. The device as claimed in claim 1 or in claim 2, characterized in that the electric power supply means comprise a microwave line ($m_i$, $c_i$ and 29) placed orthogonally in relation to the conductors and carrying a wave whose phase velocity (v) is adapted to the wavelength ($\lambda$) of a contour (22) on which the conductors (1—12) are borne.

4. The device as claimed in claim 2 or claim 3, characterized in that the electric power supply means comprising a microwave line with localized constants ($m_i$ and $c_i$), and carrying a wave whose phase velocity (v) sets a wavelength ($\lambda$) equal to the perimeter of the contour (16) on which the generatrices of the cylinder (15) lie and in that said line is fed at one first point (4—29) at least and is short circuited at two second points (1—29 and 7—29) which are diametrically opposite and are placed at a right angle in relation to the first point.

5. The device as claimed in any one of claims 1 through 3, caracterized in that the electric power supply means comprises a microwave line (35) deployed along the contour of support of the cylinder which encloses the delimited volume, with localized constants ($m_i$) and carrying a wave whose phase velocity sets a wavelength ($\lambda/2$) corresponding to the length of this contour, in that this said line comprises an array of induction coils ($m_i$) placed in series between two complementary segments (31 and 34) of two adjacent conductors and in that this said line is fed (37) at one third point (31 and 34) at least.

6. The device as claimed in claim 5, characterized in that the said third point is situated halfway up the cylinder.

7. The device as claimed in any one of the claims 3 through 6, characterized in that the lines are constituted by T cells.

8. The device as claimed in any one of the claims 3 through 6, characterized in that the lines are constituted by π cells.

9. The device as claimed in any one of the claims 1 through 8 characterized in that the array of the conductor wires is contained in a Faraday cage (27) and in that the ends of the conductor wires are connected with this cage by capacitors ($c_i$).

10. The device as claimed in any one of the claims 3 through 9, characterized in that the power supply circuit of the line comprises coaxial cables (37) whose core (36) of one end is coupled (38) magnetically with the line and whose braid (40) as a shield is electrically connected with the line.

11. The device as claimed in any one of the claims 3 through 10, characterized in that it comprises phase rotation means (44) for feeding different points ($h_i$, $k_i$, $m_i$ and $n_i$) of the line with shifted phases in such a manner as to produce an exciting magnetic field which is a rotating field ($2\pi f_o$).

12. The device as claimed in claims 11 and 5, characterized in that the line is fed at two fourth points ($h_i$ and $k_i$) respectively in a quadrature of phase in relation to two third points ($m_i$ and $n_i$).

13. The device as claimed in claims 11 and 12, characterized in that the phase rotations π/2 are obtained by placing a directive coupler (44) in a feed path and separating (42 and 47) each of the two output paths (37, 41, 48 and 49) of the coupler to form two opposite phase paths.

14. The device as claimed in any one of the claims 1 through 13, characterized in that it comprises means (70) in order to create an equipotential surface (69) and in that the trigonometrical function which modulates the intensity in each conductor is proportional to the distance $\rho \cos \theta$ between each conductor and this equipotential surface.

Fig.1a

Fig.1b

Fig.1c

Fig.1d

EP 0 170 558 B1

Fig.2

27

28

30

$c_j$

29

1

2

12

$y$

3

$c_i$

11

$z$

$m_i$

10

$x'$

$x$

$z'$

4

9

5

$y'$

8

6

7

26

$I_0 \cos(\omega_0 t)$

Fig.3a

35

30

29

32

31

1

$c_j$

$c_i$

34

2

3

12

$m_i$

11

33

36

10

4

26

9

5

$I_0 \cos(\omega_0 t)$

8

6

37

7

Fig.3b

31      $c_i$

35      $m_i$      35

35                34

38      $m_i$      34

31      36      39

Fig.3c

37      40      35

Fig.4